# EUROPEAN PATENT APPLICATION

(11) **EP 4 718 953 A2**
(43) Date of publication of application: **01.04.2026**
(21) Application number: 25203989.6
(22) Date of filing: 23.09.2025
(51) Int. Cl.: H05K 1/02, H05K 1/11, F21S 41/141, F21S 43/14, H05K 1/03, H10H 20/851

(54) **LIGHT EMITTING DEVICE**

(30) Priority: 27.09.2024 JP 2024168500
(71) Applicant: Nichia Corporation, Anan-shi, Tokushima 774-8601 (JP)
(72) Inventor: FUJIWARA, Shumpei, Anan-shi, Tokushima, 774-8601 (JP); TAMEMOTO, Kenta, Anan-shi, Tokushima, 774-8601 (JP)
(74) Representative: Betten & Resch

(57) **Abstract**

A light emitting device (1, 1A-1D, 2, 2A) includes a base member (10) formed of a ceramic material and having a through hole (10x), a first interconnect (11) disposed on an upper surface of the base member (10), a second interconnect (12) disposed on a lower surface of the base member (10), a conductive member (13) disposed inside the through hole (10x) and electrically connecting the first interconnect (11) and the second interconnect (12), a light emitting element (21, 21a-21d, 41a, 41b) disposed on the first interconnect (11) and electrically connected to the first interconnect (11), and an integrated circuit (501) disposed on the first interconnect (11) and electrically connected to the first interconnect (11).

## Description

### FIELD

The present disclosure relates to light emitting devices.

### BACKGROUND

There is a light emitting device having a light emitting element and an electronic component mounted on a substrate. Examples of such a light emitting device include vehicle lighting having a wiring board with interconnect patterns mounted on a metal base, input connectors and various circuit components constituting a current control circuit mounted on the wiring board, and a light emitting diode (LED) chip mounted on a protrusion of the metal base surrounded by a cutout of the wiring board via an auxiliary board, for example.

Japanese Patent Publication No. 2010-113849 is an example of the related art.

### SUMMARY

It is one object of the present disclosure to improve noise resistance of a light emitting device.

In one embodiment of the present disclosure, a light emitting device includes a base member formed of a ceramic material and defining a through hole, a first interconnect disposed on an upper surface of the base member, a second interconnect disposed on a lower surface of the base member, a conductive member disposed in the through hole and connecting the first interconnect and the second interconnect, a light emitting element disposed on the first interconnect and connected to the first interconnect, and an integrated circuit disposed on the first interconnect and connected to the first interconnect.

It is to be understood that both the foregoing general description and the following detailed description are exemplary and explanatory and are not restrictive of the invention.

### BRIEF DESCRIPTION OF THE DRAWINGS

FIG. 1 is a perspective view illustrating an example of a light emitting device according to a first embodiment;
FIG. 2 is a partial cross-sectional view taken along a line II-II in FIG. 1;
FIG. 3 is a top view illustrating the example of the light emitting device according to the first embodiment;
FIG. 4 is a bottom view illustrating the example of the light emitting device according to the first embodiment;
FIG. 5 is a partial cross-sectional view taken along a line V-V in FIG. 3;
FIG. 6 is a circuit diagram of the light emitting device according to the first embodiment;
FIG. 7 is a diagram for explaining a ground delay;
FIG. 8 is a diagram illustrating measurement results of a rate of change of illuminance in a (BCI) test;
FIG. 9 is a top view illustrating an example of the light emitting device according to a first modification of the first embodiment;
FIG. 10 is a bottom view illustrating an example of the light emitting device according to a second modification of the first embodiment;
FIG. 11 is a bottom view illustrating an example of the light emitting device according to a third modification of the first embodiment;
FIG. 12 is a bottom view illustrating an example of the light emitting device according to a fourth modification of the first embodiment;
FIG. 13 is a top view illustrating an example of the light emitting device according to a second embodiment;
FIG. 14 is a top view of the light emitting device according to the second embodiment, in which illustration of a light source, a frame member, and electronic components is omitted, and a position of the frame member is indicated by a broken line;
FIG. 15 is a bottom view illustrating the example of the light emitting device according to the second embodiment;
FIG. 16 is a circuit diagram of the light emitting device according to the second embodiment;
FIG. 17 is a top view illustrating an example of the light emitting device according to a first modification of the second embodiment;
FIG. 18 is a top view of the example of the light emitting device according to the first modification of the second embodiment, in which illustration of the light source, the frame member, and the electronic components is omitted, and the position of the frame member is indicated by a broken line; and
FIG. 19 is a bottom view illustrating the example of the light emitting device according to the first modification of the second embodiment.

### DETAILED DESCRIPTION

Hereinafter, certain embodiments and modifications of the present disclosure will be described with reference to the drawings. In the following description, terms indicating specific directions and positions (for example, "upper", "above", "lower", "below", and other terms related to these terms) are used as necessary. However, the use of these terms is intended to facilitate understanding of the present disclosure with reference to the drawings, and the technical scope of the present disclosure is not limited by the definitions of these terms. In addition, the same reference numerals used in the drawings denote the same or equivalent parts, members, or constituent elements.

The embodiments and modifications described below are examples of a light emitting device or the like for embodying the technical idea of the present disclosure, but the present disclosure is not limited to the following embodiments and modifications. In addition, the dimensions, materials, shapes, relative arrangements, or the like of the constituent elements described below are intended to be illustrative and not intended to limit the scope of the present disclosure thereto unless indicated otherwise. The contents described in one embodiment are also applicable to other embodiments and modifications. In addition, the sizes, positional relationships, or the like of the constituent elements illustrated in the drawings may be exaggerated for the sake of clearer illustration. Further, to avoid the drawings from becoming overly complex, a schematic view in which the illustration of some elements is omitted may be used, or an end surface view illustrating only a cut surface may be used as a cross-sectional view. The term "rectangular shape" in the present specification refers to a case where the angles of the four corners of the rectangle tolerates an error of 90 degrees ±5 degrees, and includes shapes similar to the rectangle with the tolerated error, such as shapes in which the corners of the rectangle are chamfered, rounded, or the like. In addition, in the present specification, the term "parallel" not only refers to a case where two straight lines, sides, surfaces, or the like do not intersect even when extended, but also includes a case where two straight lines, sides, surfaces, or the like intersect within a range in which an angle formed therebetween is 10° or less. In addition, in the present specification, "connection" refers to an electrical connection unless indicated otherwise.

### <First Embodiment>

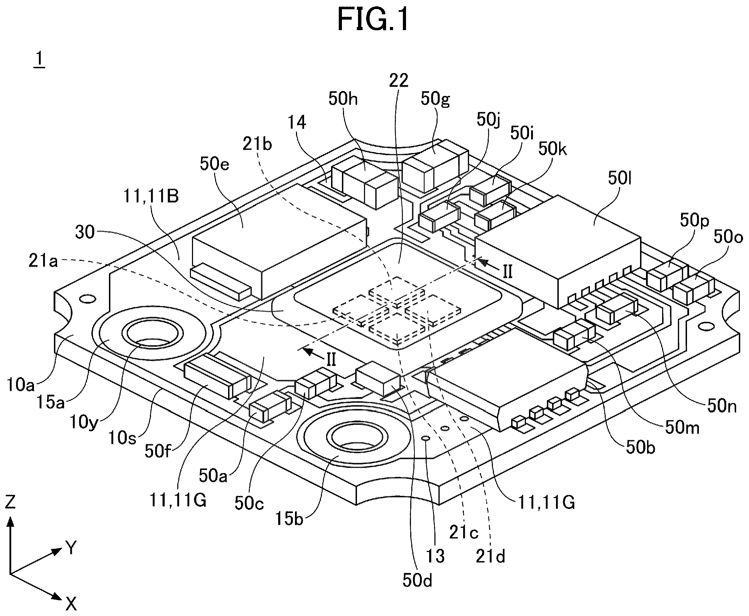

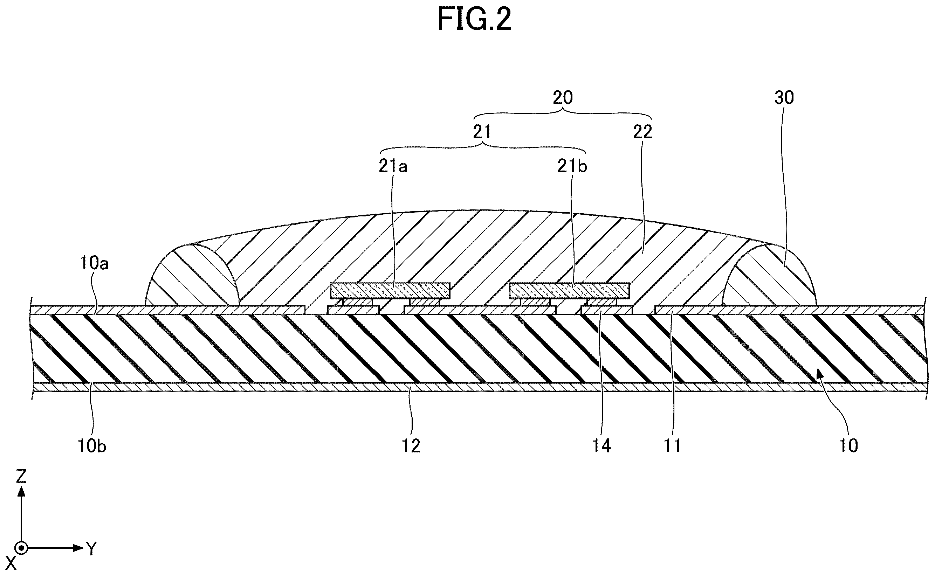

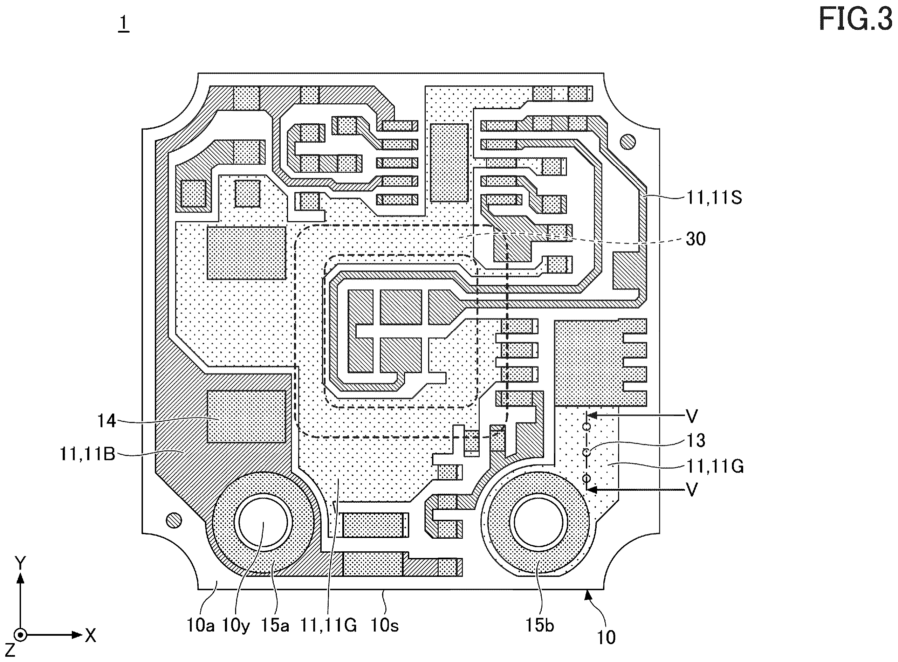

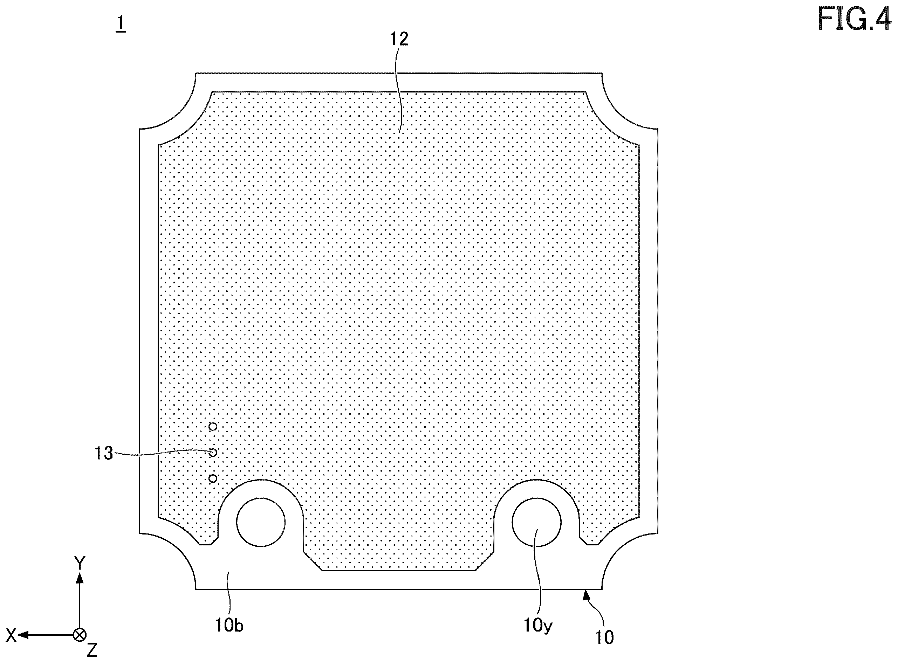

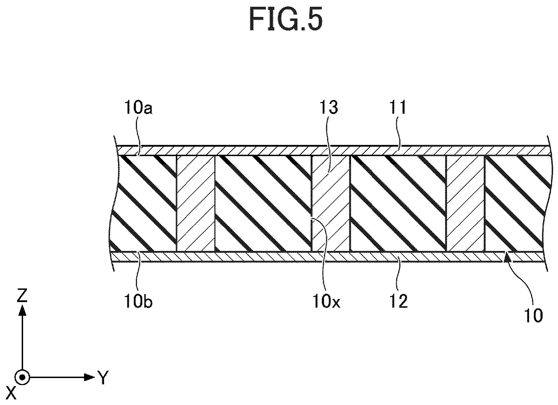

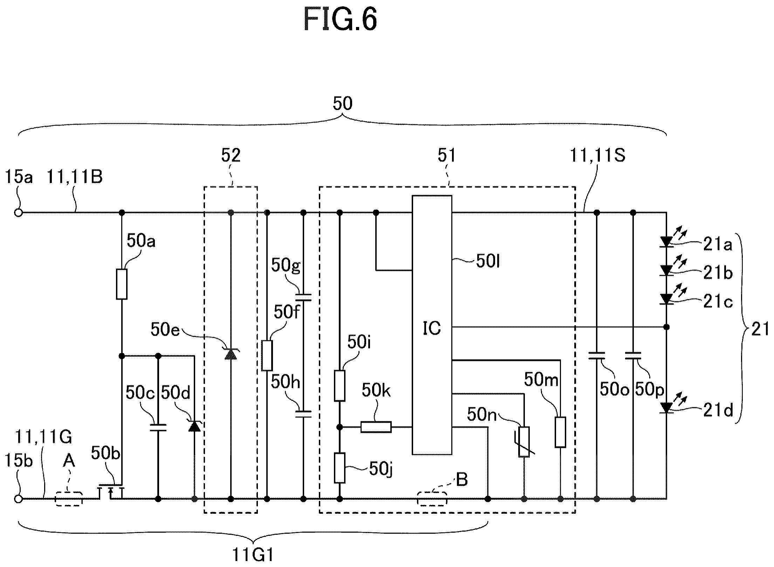

FIG. 1 is a perspective view illustrating an example of a light emitting device according to a first embodiment. FIG. 2 is a partial cross-sectional view taken along a line II-II in FIG. 1. FIG. 3 is a top view illustrating the example of the light emitting device according to the first embodiment. In FIG. 3, the illustration of a light source, a frame member, and electronic components is omitted for the sake of convenience, and a position of the frame member is indicated by a broken line. FIG. 4 is a bottom view illustrating the example of the light emitting device according to the first embodiment. FIG. 5 is a partial cross-sectional view taken along a line V-V in FIG. 3. FIG. 6 is a circuit diagram of the light emitting device according to the first embodiment.

In the drawings, an X-axis, a Y-axis, and a Z-axis that are perpendicular to one another are illustrated as references, as necessary. A direction parallel to the X-axis is referred to as a first direction X, a direction parallel to the Y-axis is referred to as a second direction Y, and a direction parallel to the Z-axis is referred to as a third direction Z. Moreover, in the first direction X, a direction in which an arrow is pointing is referred to as a +X-direction, and a direction opposite to the +X-direction is referred to as a -X-direction. In the second direction Y, a direction in which an arrow is pointing is referred to as a +Y-direction, and a direction opposite to the +Y-direction is referred to as a -Y-direction. In the third direction Z, a direction in which an arrow is pointing is referred to as a +Z-direction, and a direction opposite to the +Z-direction is referred to as a -Z-direction. However, these directions do not limit the orientation of the light emitting device in use, and the orientation of the light emitting device may be arbitrary.

As illustrated in FIG. 1 through FIG. 6, a light emitting device 1 includes a base member 10, a light source 20, a frame member 30, and a circuit 50. The light source 20, the frame member 30, and the circuit 50 are disposed on the base member 10. The frame member 30 is disposed around the light source 20. The light emitting device 1 can be used for a vehicle-mounted lighting device, such as a tail lamp and/or a stop lamp of an automobile, a motorcycle, or the like, for example.

The base member 10 is a flat plate-shaped member having insulating properties. The base member 10 includes an upper surface 10a, and a lower surface 10b. Examples of a material used for the base member 10 include ceramic materials, insulating resin materials, or the like, for example. Examples of the ceramic materials include aluminum oxide, aluminum nitride, silicon nitride, or the like, for example. Examples of the insulating resin materials include phenol resins, epoxy resins, polyimide resins, bismaleimide triazine (BT) resins, polyphthalamide, or the like, for example. Among these materials, the base member 10 is preferably formed of a ceramic material having a relatively high dielectric constant, such as aluminum oxide, aluminum nitride, silicon nitride, or the like. By using such materials for the base member 10, a first interconnect 11 and a second interconnect 12 described below can be capacitively coupled, and a relatively large electrostatic capacitance can easily be obtained. For example, the base member 10 has a rectangular shape in a plan view. In the illustrated example, the upper surface 10a and the lower surface 10b of the base member 10 are flat surfaces, and a first side 10s of the upper surface 10a is parallel to the first direction X. In addition, a normal to the upper surface 10a is parallel to the third direction Z. The shape of the base member 10 in the plan view is not limited to the rectangular shape. Unless indicated otherwise, the plan view refers to a view of the light emitting device 1 from above in a normal direction to the upper surface 10a of the base member 10.

The first interconnect 11 and lands 14 for mounting components are disposed on the upper surface 10a of the base member 10. The lands 14 are portions of the first interconnect 11, and the portions of the first interconnect 11 particularly connected to electronic components are referred to as the lands 14. A protective glass that covers the first interconnect 11, and from which the lands 14 is exposed, is provided on the upper surface 10a of the base member 10. The protective glass may be omitted, so that portions of the first interconnect 11 other than the lands 14 are also exposed.

The second interconnect 12 is disposed on the lower surface 10b of the base member 10. As illustrated in FIG. 4, the second interconnect 12 may be disposed on substantially the entire lower surface 10b of the base member 10 excluding an outer edge portion of the lower surface 10b.

As illustrated in FIG. 5, the base member 10 defines a through hole 10x extending through the base member 10 from the upper surface 10a to the lower surface 10b. A conductive member 13 is disposed inside the through hole 10x, and connects the first interconnect 11 and the second interconnect 12. In the illustrated example, an upper surface of the conductive member 13 exposed through the through hole 10x is in contact with a lower surface of the first interconnect 11, and a lower surface of the conductive member 13 exposed through the through hole 10x is in contact with an upper surface of the second interconnect 12. At least one of the first interconnect 11 and the second interconnect 12 may be provided with through hole(s) communicating with the through hole 10x. In this case, the conductive member 13 may extend from the inside of the through hole 10x into the through hole(s) provided in the first interconnect 11 and the second interconnect 12.

In the illustrated example, the base member 10 defines three through holes 10x, but the number of through holes 10x in the base member 10 may be one, two, or four or more. The through hole 10x of the base member 10 may be omitted. In this case, the first interconnect 11 and the second interconnect 12 can be connected by a conductive member disposed on lateral surface(s) of the base member 10, for example.

The light emitting device 1 may include a plurality of connection terminals connected to the circuit 50. In the example illustrated in FIG. 1 and FIG. 3, the light emitting device 1 includes, as the connection terminals, a power terminal 15a disposed on the upper surface 10a of the base member 10, and a ground terminal 15b disposed on the upper surface 10a of the base member 10.

As illustrated in FIG. 1 and FIG. 3, in a case where the power terminal 15a and the ground terminal 15b are disposed along the first side 10s of the upper surface 10a of the base member 10 in parallel to the first direction X, in the plan view, a maximum length of the second interconnect 12 in the first direction X is preferably greater than a distance connecting centers of the power terminal 15a and the ground terminal 15b in the first direction X. An area of the second interconnect 12 in a bottom view is preferably 70% or greater of an area of the lower surface 10b, more preferably 80% or greater of the area of the lower surface 10b, and further preferably 90% or greater of the area of the lower surface 10b. The larger the area of the second interconnect 12, the more a noise resistance of the light emitting device 1 can be improved. The noise resistance will be described later in detail.

The light source 20 is disposed above the upper surface 10a of the base member 10. The light source 20 includes a plurality of light emitting elements 21, and a light transmitting member 22, for example. The plurality of light emitting elements 21 may be disposed in a matrix arrangement so as to have a rectangular light emitting area as a whole in the plan view. In the example illustrated in FIG. 1, four light emitting elements 21a, 21b, 21c, and 21d having a rectangular shape in the plan view are arranged in two rows and two columns, so as to form a rectangular shape as a whole in the plan view. The light emitting elements 21a through 21d are connected to the first interconnect 11. The light emitting elements 21a through 21d may be connected in series to one another.

The light transmitting member 22 is located inward of the outer edge of the frame member 30 in the plan view, and covers the light emitting elements 21a through 21d. The frame member 30 is disposed on the upper surface 10a of the base member 10, and is disposed around the light source 20 in the plan view.

The circuit 50 is formed of a plurality of electronic components. The electronic components constituting the circuit 50 include a resistor 50a, a metal oxide semiconductor field effect transistor (MOSFET) 50b, a capacitor 50c, a Zener diode 50d, a Zener diode 50e, a resistor 50f, a capacitor 50g, a capacitor 50h, a resistor 50i, a resistor 50j, a resistor 50k, an integrated circuit 50l, a resistor 50m, a thermistor 50n, a capacitor 50o, and a capacitor 50p. The circuit 50 may include electronic components other than the electronic components described above, including the light emitting elements 21a through 21d.

The electronic components constituting the circuit 50 are disposed on the first interconnect 11 disposed on the upper surface 10a of the base member 10. The electronic components constituting the circuit 50 are connected to the first interconnect 11. The electronic components are mounted on the corresponding lands 14 for mounting components. The electronic components has one or more electrodes connected to the land(s) 14 for mounting components, via a bonding material, such as solder or the like. The electronic components may be connected to the lands 14 via bonding wires.

The conductive member 13 is preferably not in contact with the bonding material that bonds the electronic components to the first interconnect 11. In this case, it is possible to reduce a possibility of (i) reduction in metal atoms of the conductive member 13 due to diffusion into the bonding material that bonds the electronic components and (ii) increase in a resistance of the conductive member 13. As a result, the first interconnect 11 and the second interconnect 12 can be connected by the conductive member 13 with a low impedance.

As illustrated in FIG. 3 and FIG. 6, the first interconnect 11 may include a ground interconnect 11G connected to the ground terminal 15b, a power interconnect 11B connected to the power terminal 15a, and a signal interconnect 11S connected to the integrated circuit 501. The signal interconnect 11S may connect electronic components other than the integrated circuit 501.

At least a portion of each of the ground interconnect 11G, the power interconnect 11B, and the signal interconnect 11S overlaps the second interconnect 12 in the plan view. Entirety of each of the ground interconnect 11G, the power interconnect 11B, and the signal interconnect 11S may overlap the second interconnect 12 in the plan view. In FIG. 3, for the sake of convenience, the ground interconnect 11G is indicated by a light dot pattern, the lands 14 are indicated by a dark dot pattern, and the power interconnect 11B and the signal interconnect 11S are indicated by hatchings of mutually different inclination angles.

The ground interconnect 11G may include a first ground interconnect 11G1 that connects the ground terminal 15b and the integrated circuit 501. The conductive member 13 is preferably located at a position overlapping the first ground interconnect 11G1 in the plan view. In this case, the second interconnect 12 becomes the same potential as the first ground interconnect 11G1, thereby stabilizing a ground potential of the integrated circuit 50l. For example, in FIG. 1, a part connecting the ground terminal 15b and MOSFET 50b is a portion of the first ground interconnect 11G1, and three conductive members 13 are located at positions overlapping this portion of the first ground interconnect 11G1 in the plan view. Accordingly, the second interconnect 12 can easily have the same potential as the ground terminal 15b, thereby stabilizing the ground potential of the integrated circuit 501. The part connecting the ground terminal 15b and MOSFET 50b corresponds to a position indicated by a broken line A in the circuit diagram of FIG. 6.

As described above, in the light emitting device 1, the base member 10 is formed of a ceramic material, the first interconnect 11 is disposed on the upper surface 10a of the base member 10, and the second interconnect 12 is disposed on the lower surface 10b of the base member 10. The first interconnect 11 and the second interconnect 12 are connected via the conductive member 13. Because the first interconnect 11 and the second interconnect 12 have portions opposing each other with the base member 10 interposed therebetween, the first interconnect 11 and the second interconnect 12 are capacitively coupled. When the base member 10 is formed of a ceramic material, the first interconnect 11 and the second interconnect 12 are easily capacitively coupled, and a relatively large electrostatic capacitance can be obtained. For this reason, noise that enters the first interconnect 11 from the power terminal 15a can be released to the second interconnect 12 side, for example. Hence, noise resistance of the light emitting device 1 can be improved. For example, when noise enters the first interconnect 11 from the power terminal 15a, a voltage applied to the integrated circuit 501 varies, and the integrated circuit 50l cannot correctly drive the light emitting elements 21a through 21d, causing a change in illuminance in some cases. Accordingly, the change in illuminance can be reduced by allowing the noise entering the first interconnect 11 side to be released to the second interconnect 12 side.

In the plan view, a total area of portions of the first interconnect 11 where the electronic components are not disposed is preferably larger than a total area of portions of the first interconnect 11 where the electronic components are disposed. Particularly, it is preferable to increase an area of the ground interconnect 11G. More particularly, the area of the ground interconnect 11G is preferably greater than or equal to approximately 40% of the area of the lower surface 10b of the base member 10. By increasing the area of the ground interconnect 11G, functions of the ground interconnect 11G as a ground plane can be enhanced, and a shielding effect on the upper surface 10a side of the base member 10 can be improved. Further, a thickness of the ground interconnect 11G is preferably greater than or equal to 10 µm and less than or equal to 105 µm, for example. When the thickness of the ground interconnect 11G is greater than or equal to 10 µm, an impedance of the ground interconnect 11G can be reduced, and the noise resistance can be improved. When the thickness of the ground interconnect 11G is less than or equal to 105 µm, heat dissipation of the light emitting device 1 can be improved.

In the plan view of the entire base member 10, a first area that is a portion where the first interconnect 11 and the second interconnect 12 overlap each other is preferably greater than a second area that is a portion where the first interconnect 11 and the second interconnect 12 do not overlap each other. The first area is preferably greater than or equal to 50% of a sum of the first area and the second area. By increasing the first area, an electrostatic capacitance of a capacitor formed of the first interconnect 11, the base member 10, and the second interconnect 12 can be increased. Hence, the noise entering the first interconnect 11 from the power terminal 15a can easily be released to the second interconnect 12 side, for example, and the noise resistance of the light emitting device 1 can further be improved.

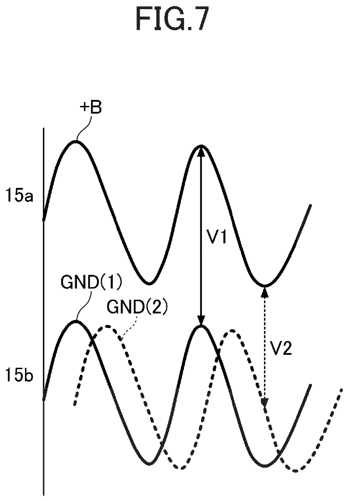

Further, in the light emitting device 1, in a case where the first interconnect 11 includes the ground interconnect 11G, and the second interconnect 12 is connected to the ground interconnect 11G via the conductive member 13, a ground delay caused by the noise can be reduced. FIG. 7 is a diagram for explaining the ground delay. For example, it is assumed that a voltage +B illustrated in FIG. 7 is input from the power terminal 15a. The voltage +B varies periodically due to the noise. In this case, if a voltage of the ground terminal 15b is GND(1) which has the same magnitude and the same phase as the voltage +B, the voltage +B with respect to the voltage GND(1) becomes a constant voltage V1, and no voltage variation occurs.

On the other hand, when the ground delay caused by the noise occurs, the voltage of the ground terminal 15b becomes GND(2) which has a phase different from the phase of the voltage +B, and the voltage +B with respect to the voltage GND(2) becomes a non-constant voltage V2. That is, the voltage B+ with respect to the voltage GND(2) becomes the non-constant voltage V2, and a voltage variation occurs. It may be regarded that the ground delay is caused by an impedance mismatch between an interconnect connected to the power terminal 15a and an interconnect connected to the ground terminal 15b. When the non-constant voltage V2 is applied to the integrated circuit 501, the integrated circuit 501 cannot drive the light emitting elements 21a through 21d correctly when the voltage V2 decreases, and a change in illuminance occurs. According to studies conducted by the present inventors, it may be regarded that the ground delay caused by the noise occurs when the second interconnect 12 is not disposed on the lower surface 10b of the base member 10, and that the ground delay can be reduced by disposing the second interconnect 12 on the lower surface 10b of the base member 10. Results of tests conducted by the present inventors are illustrated below.

The present inventors performed a bulk current injection (BCI) test in conformance with ISO 11452-4 standard. The BCI test is a test for evaluating a resistance of a vehicle-mounted product, such as a light emitting device or the like, when magnetic field noise is induced in the vehicle-mounted product. A rate of change of illuminance of the light emitting device was measured when magnetic field noise in a range greater than or equal to 1 MHz and less than or equal to 500 MHz is simultaneously induced at the power terminal and the ground terminal of the light emitting device. A sample 1 having the same configuration as the light emitting device 1 illustrated in FIG. 1 through FIG. 6, and a sample 2 obtained by removing all of the second interconnect 12 and the conductive member 13 from the light emitting device 1, were used for the measurement.

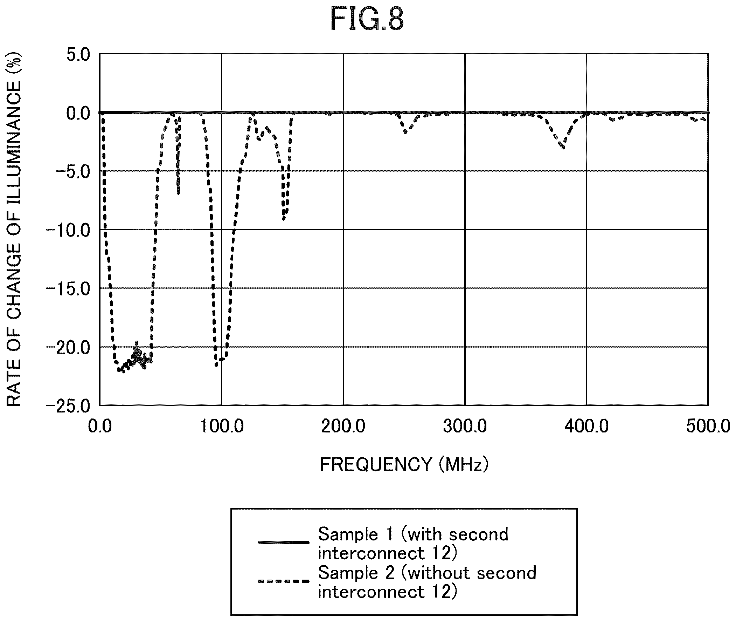

FIG. 8 is a diagram illustrating measurement results of the rate of change of illuminance in the BCI test. As illustrated in FIG. 8, in the sample 1 having the second interconnect 12, a change in illuminance did not occur even when the magnetic field noise in the range greater than or equal to 1 MHz and less than or equal to 500 MHz was induced. In contrast, in the sample 2 not having the second interconnect 12, a large change in illuminance exceeding 20% was observed when the magnetic field noise less than or equal to 150 MHz was induced, and a slight change in illuminance of approximately several % was observed even when the magnetic field noise greater than or equal to 200 MHz was induced. In the sample 2, it may be regarded that the ground delay occurs due to induction of the magnetic field noise, the voltage applied to the integrated circuit 50l decreases, and the integrated circuit 50l cannot correctly drive the light emitting elements 21a through 21d, thereby causing the change in illuminance. On the other hand, in the sample 1, it may be regarded that the provision of the second interconnect 12 on the lower surface 10b of the base member 10 causes the ground interconnect 11G connected to the ground terminal 15b to have a low impedance, and the first interconnect 11 and the second interconnect 12 to be capacitively coupled to each other, so that noise is released to the second interconnect 12 side, thereby reducing the ground delay caused by the noise, and causing no change in illuminance.

Hereinafter, each constituent element of the light emitting device 1 will be described.

### (Base Member 10)

In a case where the base member 10 has a rectangular shape in the plan view, a length of each side of the upper surface 10a and the lower surface 10b may be greater than or equal to approximately 10 mm and less than or equal to approximately 30 mm, for example. A thickness of the base member 10 may be greater than or equal to approximately 0.1 mm and less than or equal to approximately 2.0 mm, for example. The upper surface 10a and the lower surface 10b may have a circular shape or a polygonal shape in the plan view.

### (First Interconnect 11, Second Interconnect 12, Conductive Member 13, and Lands 14)

The first interconnect 11, the second interconnect 12, and the lands 14 may be formed of a conductive material, such as gold, silver, copper, aluminum, or the like. The conductive member 13 may be formed of a material having conductivity, such as copper paste, silver paste, or the like. In the plan view, a length of the ground interconnect 11G in the first direction X and a length of the ground interconnect 11G in the second direction Y are preferably greater than or equal to 1.5 mm. In this case, an impedance of the ground interconnect 11G decreases, and thus, the noise resistance of the light emitting device 1 can further be improved. In the plan view, a total area of the conductive member 13 is preferably greater than or equal to 0.03 mm². In this case, the conductive member 13 can have a low impedance, and the first interconnect 11 and the second interconnect 12 are connected via the low-impedance conductive member 13, thereby further improving the noise resistance of the light emitting device 1.

### (Power Terminal 15a and Ground Terminal 15b)

The power terminal 15a and the ground terminal 15b may be disposed along the first side 10s located at the outer edge of the upper surface 10a of the base member 10, for example. The power terminal 15a and the ground terminal 15b may be provided around the through hole 10y extending through the base member 10. The power terminal 15a and the ground terminal 15b may be formed of a conductive material, such as metals including gold, silver, copper, aluminum, or the like. Three or more connection terminals may be disposed along the outer edge of the upper surface 10a in the plan view, for example.

### (Light Emitting Elements 21a through 21d)

The light emitting elements 21a through 21d are mounted on the lands 14 for mounting components. The light emitting elements 21a through 21d are preferably flip-chip mounted on the first interconnect 11 disposed on the upper surface 10a of the base member 10. When performing the flip-chip mounting, electrodes of the light emitting elements 21a through 21d and the lands 14 on the base member 10 can be electrically bonded using a bonding material, such as eutectic solder, conductive paste, bumps, or the like.

The light emitting elements 21a through 21d are light emitting diodes, for example. The specific configuration of the light emitting elements 21a through 21d may be arbitrary as long as the light emitting elements 21a through 21d can emit light having a predetermined wavelength. For example, the light emitting elements 21a through 21d may be LED chips housed in a package, or may be standalone LED chips (bare chips). The light emitting elements 21a through 21d are preferably bare chips flip-chip mounted on the base member 10. In this case, a size of the light emitting device 1 can be reduced.

The wavelength of the light emitted from the light emitting elements 21a through 21d is set appropriately according to the application of the light emitting device 1. The plurality of light emitting elements 21 are blue light emitting elements that emit blue light, for example. In this case, the light emitting elements 21a through 21d include a nitride-based semiconductor (In_{X}Al_{Y}Ga_{1-X-Y}N, 0 <= X, 0 <= Y, X + Y <= 1), for example. In the case where the light emitting elements 21a through 21d are the light emitting elements including the nitride-based semiconductor that emits blue light, a forward voltage of the light emitting elements 21a through 21d is greater than or equal to 2.4 V, for example.

### (Light Transmitting Member 22)

An upper surface of the light transmitting member 22 has an approximately rectangular shape. With this configuration, the frame member 30 can be disposed in a rectangular picture-frame shape surrounding the light source 20, and thus, a plurality of electronic components having a rectangular shape in the plan view can be disposed efficiently on the upper surface 10a of the base member 10 along the frame member 30.

The upper surface of the light transmitting member 22 is located above an upper surface of the frame member 30, and constitutes a light emitting surface of the light source 20 (that is, a light emitting surface of the light emitting device 1). The light transmitting member 22 is light transmissive, so that light emitted from the light emitting elements 21a through 21d is transmitted through the light transmitting member 22. The light transmitting member 22 includes a resin, for example. Examples of the resin used for the light transmitting member 22 include known light transmitting resins, such as silicone resins, epoxy resins, or the like, for example. Among these resins, a silicone resin (specifically, a phenyl silicone resin, a dimethyl silicone resin, or the like) having an good reliability may be suitably used as the light transmitting resin.

The light transmitting member 22 may be a wavelength conversion member including phosphor. The phosphor is excited by the light emitted from the light emitting elements 21a through 21d, and emits light having a wavelength different from the wavelength of the light emitted by the light emitting elements 21a through 21d. For example, in the case where the light emitting elements 21a through 21d emit blue light, the wavelength conversion member may include red phosphor. In this case, in the light emitting device 1, the wavelength conversion member can be excited by blue light to emit red light. According to this configuration, a driving voltage becomes high compared to that for a configuration in which red light is emitted using red light emitting elements, and thus, the light emitting elements 21a through 21d themselves are less likely to be affected by the noise.

Examples of the phosphor include oxynitride-based phosphors, nitride-based phosphors, fluoride-based phosphors, quantum dots, or the like, for example. Examples of the oxynitride-based phosphors include yttrium-aluminum-garnet-based phosphors (for example, (Y, Gd)₃(Al, Ga)₅O₁₂:Ce), lutetium-aluminum-garnet-based phosphors (for example, Lu₃(Al, Ga)₅O₁₂:Ce), terbium-aluminum-garnet-based phosphors (for example, Tb₃(Al, Ga)₅O₁₂:Ce), CCA-based phosphors (for example, Ca₁₀ (PO₄)₆Cl₂:Eu), SAE-based phosphors (for example, Sr₄Al₁₄O₂₅:Eu), chlorosilicate-based phosphors (for example, Ca₈MgSi₄O₁₆Cl₂:Eu), silicate-based phosphors (for example, (Ba, Sr, Ca, Mg)₂SiO₄:Eu), β-sialon-based phosphors (for example, (Si, Al)₃(O, N)₄:Eu), α-sialon-based phosphors (for example, Ca(Si, Al)₁₂(O, N)₁₆:Eu), or the like, for example. Examples of the nitride-based phosphors include LSN-based phosphors (for example, (La, Y)₃Si₆N₁₁:Ce), BSESN-based phosphors (for example, (Ba, Sr)₂Si₅N₈:Eu), SLA-based phosphors (for example, SrLiAl₃N₄:Eu), CASN-based phosphors (for example, CaAlSiN₃:Eu), SCASN-based phosphors (for example, (Sr, Ca)AlSiN₃:Eu), or the like, for example. Examples of the fluoride-based phosphors include KSF-based phosphors (for example, K₂SiF₆:Mn), KSAF-based phosphors (for example, K₂(Si₁₋ₓAlₓ)F₆₋ₓ:Mn, where x satisfies 0 < x < 1), MGF-based phosphors (for example, 3.5MgO·0.5MgF₂·GeO₂:Mn), or the like, for example. Examples of the quantum dots include quantum dots having a perovskite structure (for example, (Cs, FA, MA) (Pb, Sn) (F, Cl, Br, I)₃, where FA and MA represent formamidinium and methylammonium, respectively), II-VI group quantum dots (for example, CdSe), III-V group quantum dots (for example, InP), quantum dots having a chalcopyrite structure (for example, (Ag, Cu) (In, Ga) (S, Se)₂), or the like, for example.

### (Frame Member 30)

The frame member 30 preferably has light-blocking properties. The frame member 30 includes a resin, for example. The frame member 30 may be formed of a resin obtained by adding a pigment to the example of the light transmitting resin used for the light transmitting member 22, to impart the light-blocking properties. In the frame member 30, a filler, such as a white pigment, may be added to the resin to enhance light reflectivity. Titanium oxide, aluminum oxide, zinc oxide, barium carbonate, barium sulfate, boron nitride, aluminum nitride, glass filler, or the like may be suitably used as the filler. The frame member 30 may further include a black pigment, such as carbon black, graphite, titanium black, or the like.

### (Circuit 50)

The circuit 50 includes a drive circuit 51 that drives the light emitting elements 21 included in the light source 20, and a protection circuit 52 that protects the drive circuit 51 and the light emitting elements 21. In the example illustrated in FIG. 6, the drive circuit 51 is formed of the resistor 50i, the resistor 50j, the resistor 50k, the integrated circuit 501, the resistor 50m, and the thermistor 50n.

The light emitting elements 21a through 21d are connected in series to an output side of the integrated circuit 501. A voltage supplied from the outside is preferably supplied to the integrated circuit 501 without passing through an active element (for example, a rectifier diode) which causes a voltage drop. In this case, more of the voltage supplied from the outside can be used to drive the light emitting elements 21a through 21d. In the case where the light emitting elements 21a through 21d are blue light emitting diodes, the forward voltage is relatively high, and thus, it is more significant that the voltage supplied from the outside is supplied to the integrated circuit 501 without passing through an active element. By including the integrated circuit 50l, the drive circuit 51 can control current values flowing through the light emitting elements 21a through 21d.

The resistor 50i, the resistor 50j, and the resistor 50k set an operating voltage of the circuit 501. The resistor 50m sets an output current of the integrated circuit 501. The thermistor 50n detects an ambient temperature around the integrated circuit 50l. The integrated circuit 501 can control the current values flowing through the light emitting elements 21a through 21d when the temperature of the base member 10 rises, for example, based on the temperature detected by the thermistor 50n.

The drive circuit 51 may have a first operation mode in which all of the light emitting elements 21a through 21d connected in series are caused to emit light simultaneously, and a second operation mode in which the light emitting elements 21a, 21b, and 21c connected in series are caused to emit light and the light emitting element 21d is caused not to emit light. The second operation mode is effective in a case where the voltage applied across the power terminal 15a and the ground terminal 15b decreases and it is difficult to drive the four light emitting elements 21a through 21d simultaneously, for example.

In the example illustrated in FIG. 6, the protection circuit 52 is formed of the Zener diode 50e connected between the power terminal 15a and the ground terminal 15b. The protection circuit 52 may be formed of a plurality of Zener diodes connected in series with opposite polarities. The protection circuit 52 is connected in parallel with the drive circuit 51. The protection circuit 52 is disposed on an input side of the drive circuit 51. The protection circuit 52 protects the integrated circuit 50l, the light emitting elements 21, or the like from an excessively large voltage.

From a viewpoint of supplying the voltage, which is required to drive the light emitting elements 21, to the drive circuit 51, and from a viewpoint of protecting the drive circuit 51, the light emitting elements 21, or the like from an excessively large voltage, a Zener voltage of the Zener diode 50e is preferably in a range of approximately 16 V to approximately 40 V.

The circuit 50 may include a circuit other than the drive circuit 51 and the protection circuit 52, as necessary. In the example illustrated in FIG. 6, the circuit 50 includes the resistor 50a, the MOSFET 50b, the capacitor 50c, the Zener diode 50d, the resistor 50f, the capacitor 50g, the capacitor 50h, the capacitor 50o, and the capacitor 50p, in addition to the drive circuit 51 and the protection circuit 52.

The resistor 50a, the MOSFET 50b, the capacitor 50c, and the Zener diode 50d constitute a reverse connection protection circuit, and are connected to output sides of the power terminal 15a and the ground terminal 15b. The resistor 50a controls a current value flowing through the MOSFET 50b. The MOSFET 50b is a field effect transistor, and prevents a current from flowing from the ground terminal 15b to the power terminal 15a side. The capacitor 50c protects the MOSFET 50b when a sudden over-voltage is applied in the reverse direction. The Zener diode 50d protects the resistor 50a side of the MOSFET 50b so that a voltage applied to the resistor 50a side of the MOSFET 50b does not exceed a maximum allowable rating when a current flows from the power terminal 15a to the ground terminal 15b side.

One end of the resistor 50a is connected to the power terminal 15a, and the other end of the resistor 50a is connected to a gate of the MOSFET 50b, one end of the capacitor 50c, and a cathode of the Zener diode 50d. In addition, a source of the MOSFET 50b is connected to the ground terminal 15b, and the other end of the capacitor 50c and an anode of the Zener diode 50d are connected to a drain of the MOSFET 50b. In this circuit, because a gate of the MOSFET 50b is biased, a voltage drop between the drain and the source of the MOSFET 50b is reduced, thereby implementing a reverse connection protection circuit with a reduced voltage consumption.

The resistor 50f is a pull-down resistor, and is connected between the power terminal 15a and the ground terminal 15b. The capacitors 50g and 50h are capacitors for noise suppression of the integrated circuit 501, and are connected in series between the power terminal 15a and the ground terminal 15b. The capacitors 50o and 50p are capacitors for noise suppression of the light emitting elements 21, and are connected in parallel with the light emitting elements 21. The capacitors 50g, 50h, 50o, and 50p can reduce radio frequency noise from sources such as wireless communications, induced noise in cables, or the like, for example.

The circuit configuration illustrated in FIG. 6 is an example, and the light emitting device 1 may have other circuit configurations. The circuit configuration of the light emitting device 1 can be modified, as appropriate, depending on the application or the like of the light emitting device 1.

### <First Modification of First Embodiment>

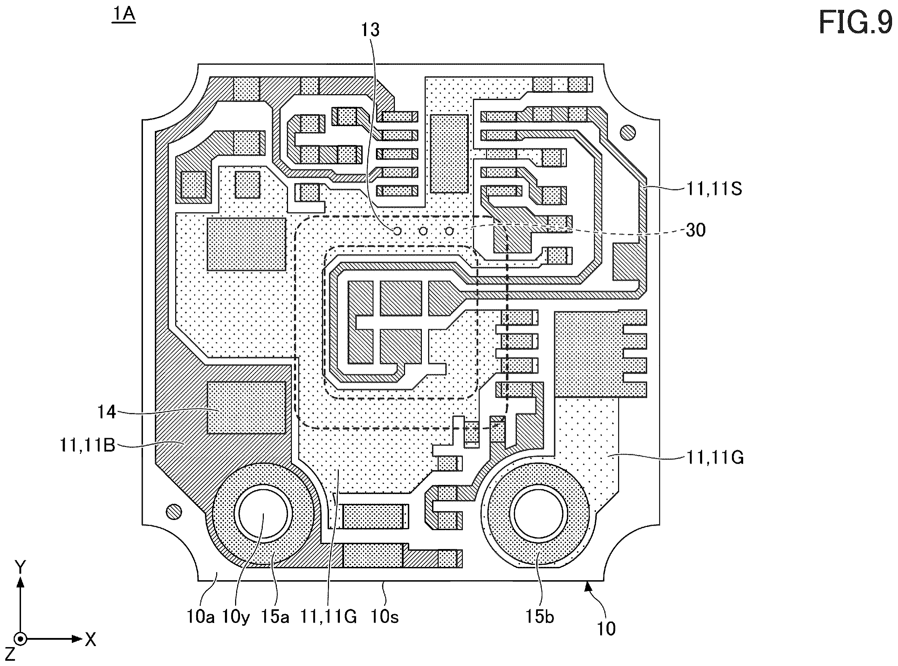

FIG. 9 is a top view illustrating an example of the light emitting device according to a first modification of the first embodiment. In FIG. 9, the illustration of the light source, the frame member, and the electronic components is omitted for the sake of convenience, and the position of the frame member is indicated by a broken line.

In a light emitting device 1A illustrated in FIG. 9, a position of the conductive member 13 differs from that of the light emitting device 1 illustrated in FIG. 3. In the light emitting device 1A, the conductive member 13 is disposed at a position B indicated by a broken line in the circuit diagram of FIG. 6, that is, in a vicinity of the integrated circuit 501. The position B indicated by the broken line in the circuit diagram of FIG. 6 is included in the first ground interconnect 11G1.

As described above, the position of the conductive member 13 is not particularly limited, and the conductive member 13 may be disposed at an arbitrary position on the base member 10. The noise resistance of the light emitting device 1 can be improved regardless of the position of the conductive member 13 on the base member 10.

### <Second Modification of First Embodiment>

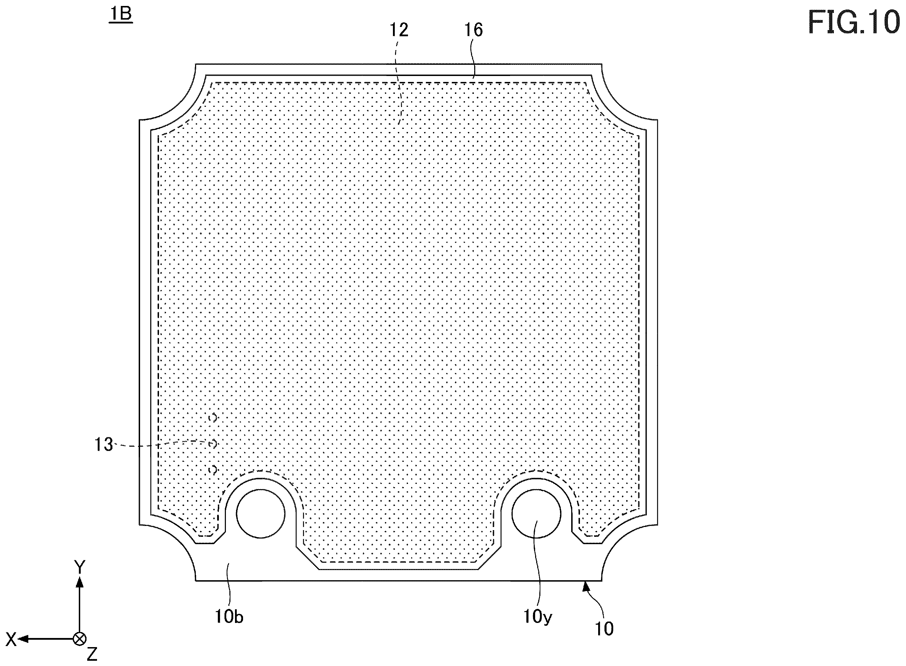

FIG. 10 is a bottom view illustrating an example of the light emitting device according to a second modification of the first embodiment. A light emitting device 1B illustrated in FIG. 10 differs from the light emitting device 1 illustrated in FIG. 4 in that an insulating film 16, disposed on the lower surface of the second interconnect 12, is provided on the lower surface 10b of the base member 10. The insulating film 16 may be disposed so as to cover the entire second interconnect 12 in the bottom view. The insulating film 16 may be disposed so as to cover a part or an entirety of the lower surface 10b of the base member 10, at the lower surface 10b of the base member 10 exposed from the second interconnect 12 in the bottom view. A material used for the insulating film 16 may be glass, for example.

By disposing the insulating film 16 on the lower surface of the second interconnect 12 in this manner, the electrostatic capacitance of the capacitor formed of the first interconnect 11, the base member 10, and the second interconnect 12 can be stabilized. In addition, when the light emitting device 1 is disposed on a conductive member, such as a metal plate or the like, the second interconnect 12 and the conductive member can be insulated from each other. As a result, the light emitting device 1 can be disposed on a metal plate for heat dissipation, for example.

### <Third Modification of First Embodiment>

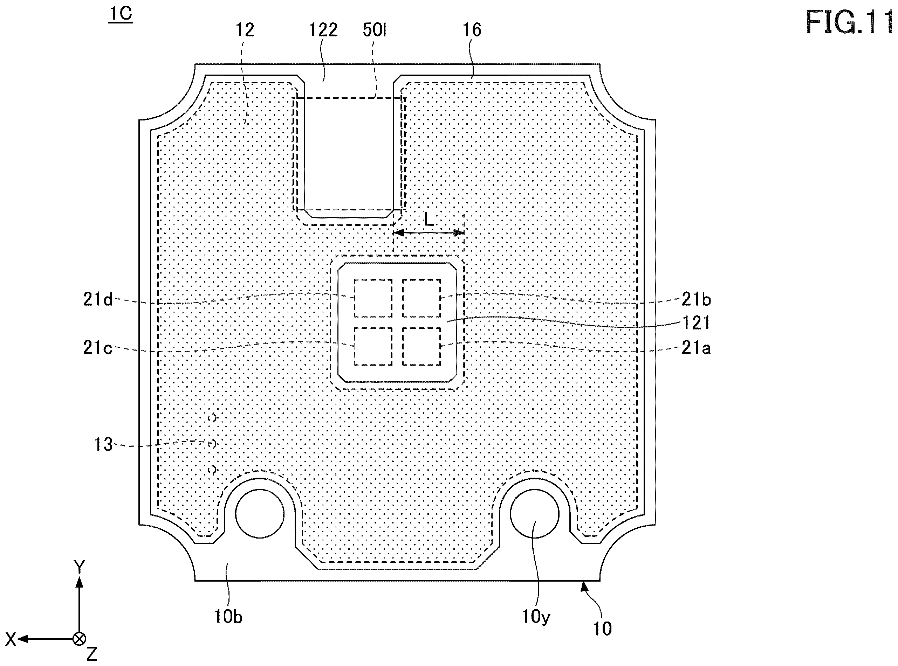

FIG. 11 is a bottom view illustrating an example of the light emitting device according to a third modification of the first embodiment. In a light emitting device 1C illustrated in FIG. 11, the lower surface 10b of the base member 10 overlaps the light emitting elements 21a through 21d in the plan view, and has a first area 121 where the second interconnect 12 is not disposed. Further, the lower surface 10b of the base member 10 overlaps the integrated circuit 50l in the plan view, and includes a second area 122 in which the second interconnect 12 is not disposed. The first area 121 and the second area 122 are located apart from each other. At least a portion of the first area 121 and the second area 122 is exposed from the insulating film 16.

For example, in the case where the insulating film 16 is formed of glass, because glass has a relatively low thermal conductivity, the heat dissipation properties may degrade if the insulating film 16 is disposed on the lower surface sides of the light emitting elements 21a through 21d and the integrated circuit 50l which are likely to generate heat during operation.

Accordingly, by providing the first area 121 where the second interconnect 12 is not disposed at a position overlapping the light emitting elements 21a through 21d in the plan view, and exposing at least a portion of the first area 121 from the insulating film 16, the heat dissipation properties with respect to the heat that is generated from the light emitting elements 21a through 21d can be improved. As a result, a temperature variation of the light emitting elements 21a through 21d is reduced, and the light emitting device 1C can operate more stably against noise.

Similarly, by providing the second area 122 in which the second interconnect 12 is not disposed at a position overlapping the integrated circuit 501 in the plan view, and exposing at least a part of the second area 122 from the insulating film 16, the heat dissipation properties with respect to the heat that is generated from the integrated circuit 501 can be improved. As a result, a temperature variation of the integrated circuit 50l is reduced, and the light emitting device 1C can operate more stably against noise.

The first area 121 is preferably continuously surrounded by the second interconnect 12. In this case, the heat that is generated from the light emitting elements 21a through 21d can be dissipated by the second interconnect 12, and the heat dissipation properties with respect to the heat that is generated from the light emitting elements 21a through 21d can be improved. For this reason, the temperature variations of the light emitting elements 21a through 21d and the integrated circuit 501 are reduced, and the light emitting device 1C can operate more stably against noise. The second interconnect 12 and the insulating film 16 preferably do not continuously surround at least a portion of the second area 122. In this case, it is easier to dispose the integrated circuit 50l at a position away from the light emitting elements 21a through 21d that are likely to generate heat during operation. Hence, the temperature variation of the integrated circuit 501 is reduced, and the light emitting device 1C can operate more stably against noise.

Moreover, at least a portion of the first area 121 preferably does not overlap the second area 122 in the second direction Y. In the illustrated example, the first area 121 does not overlap the second area 122 in a range L. Accordingly, it easier to dispose the integrated circuit 501, and the light emitting elements 21a through 21d that are likely to generate heat during operation, apart from each other. Thus, the heat dissipation properties can be improved, and the light emitting device 1C can operate more stably against noise.

It is possible to provide only one of the first area 121 and the second area 122.

### <Fourth Modification of First Embodiment>

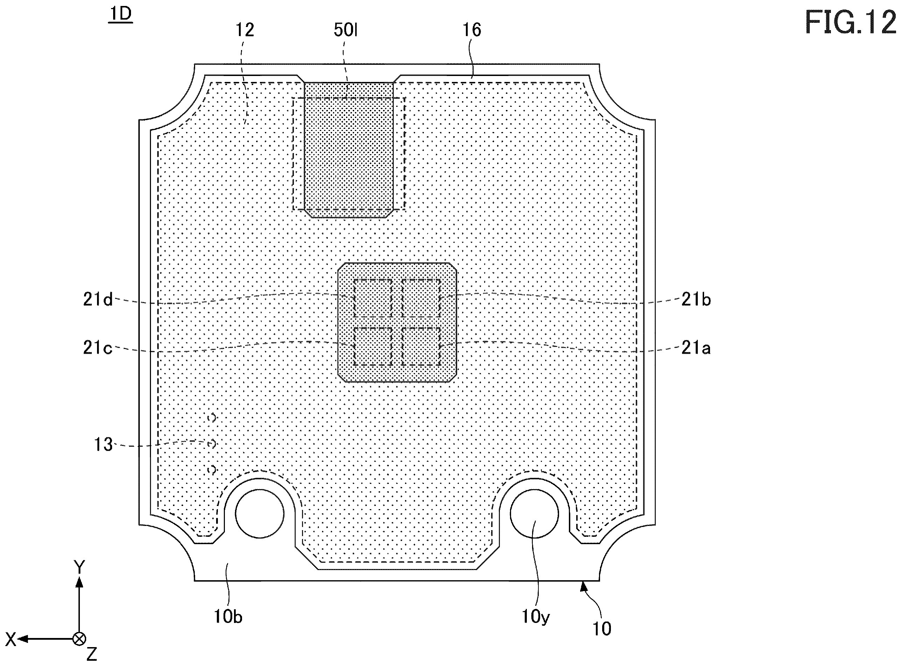

FIG. 12 is a bottom view illustrating an example of the light emitting device according to a fourth modification of the first embodiment. In a light emitting device 1D illustrated in FIG. 12, the lower surface 10b of the base member 10 does not have the first area 121 and the second area 122 illustrated in FIG. 11. The position where the insulating film 16 is disposed is the same as that in FIG. 11.

That is, in the light emitting device 1D, the second interconnect 12 is disposed at a position overlapping the light emitting elements 21a through 21d in the plan view and a position overlapping the integrated circuit 501 in the plan view. At least a portion of the second interconnect 12 disposed at the position overlapping the light emitting elements 21a through 21d in the plan view is exposed from the insulating film 16. At least a portion of the second interconnect 12 disposed at the position overlapping the integrated circuit 501 in the plan view is exposed from the insulating film 16. In FIG. 12, the portions of the second interconnect 12 exposed from the insulating film 16 are indicated by a dark dot pattern for the sake of convenience.

Because an area of the second interconnect 12 in the light emitting device 1D is larger than the area of the second interconnect 12 in the light emitting device 1C, the noise resistance can further be improved in the light emitting device 1D when compared to the light emitting device 1C. Further, in the light emitting device 1D, at least the portions of the second interconnect 12 disposed at the positions overlapping the light emitting elements 21a through 21d and the integrated circuit 50l in the plan view are exposed from the insulating film 16, and thus, the light emitting device 1D can have heat dissipation properties similar to those of the light emitting device 1C.

### <Second Embodiment>

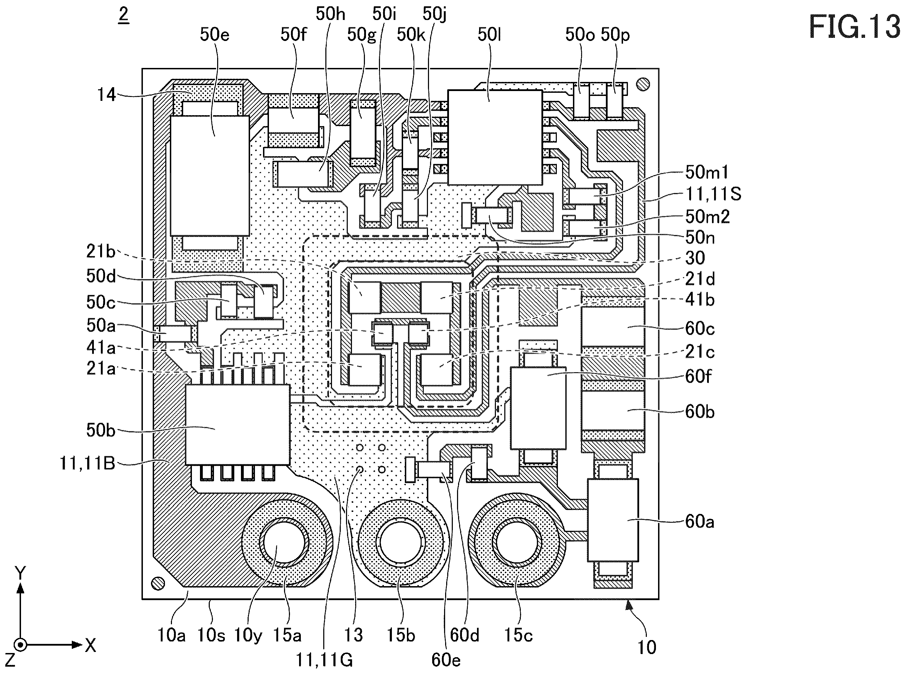

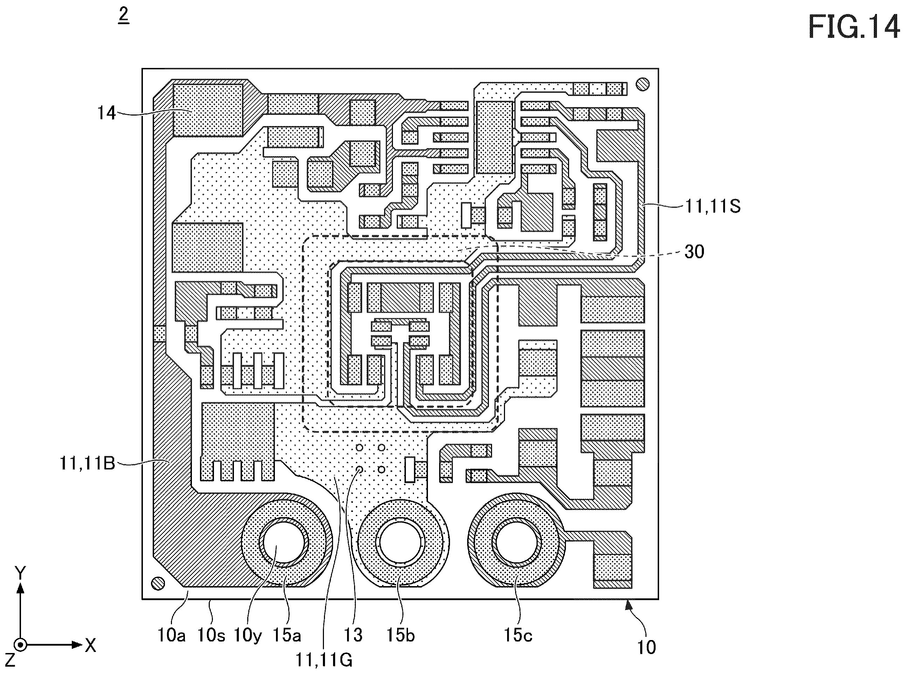

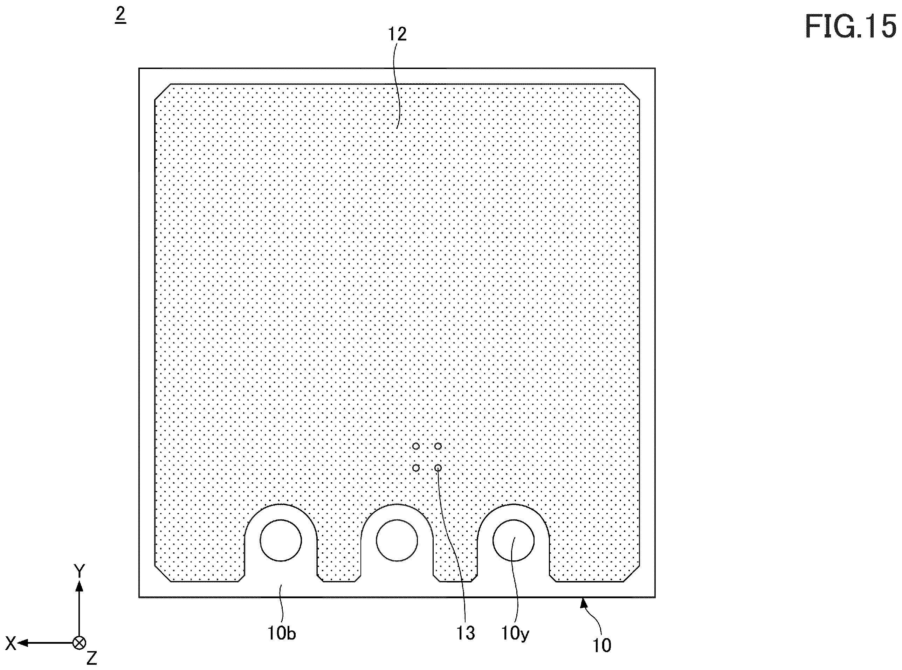

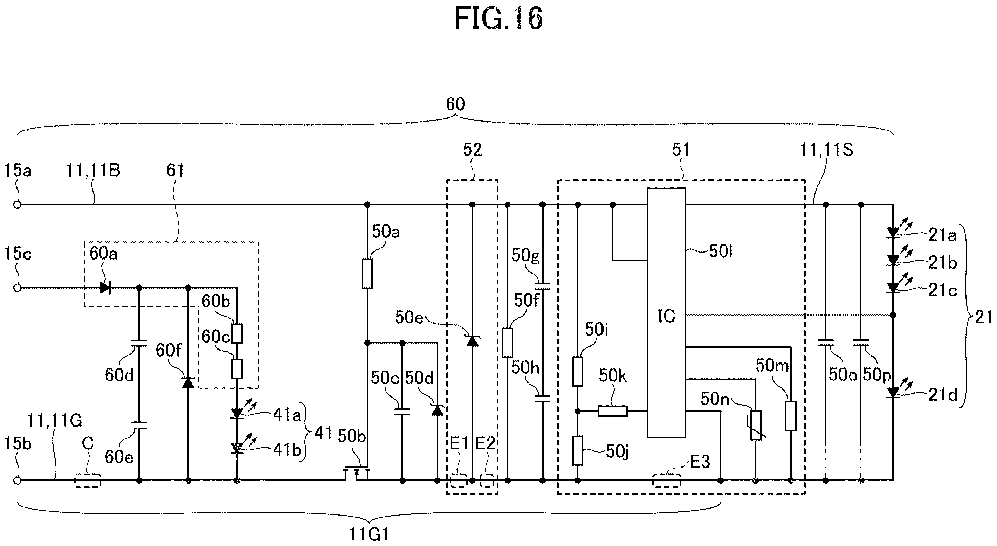

In a second embodiment, an example of a light emitting device having two drive circuits will be described. FIG. 13 and FIG. 14 are top views illustrating the light emitting device according to the second embodiment. In FIG. 13, the illustration of the light transmitting member and the frame member is omitted for the sake of convenience, and the position of the frame member is indicated by a broken line. Further, in FIG. 14, the illustration of the light source, the frame member, and the electronic components is omitted for the sake of convenience, and the position of the frame member is indicated by a broken line. FIG. 15 is a bottom view illustrating the example of the light emitting device according to the second embodiment. FIG. 16 is a circuit diagram of the light emitting device according to the second embodiment.

As illustrated in FIG. 13 through FIG. 16, a light emitting device 2 includes a light emitting element 41 in addition to the light emitting elements 21a through 21d of the light emitting device 1. The light emitting element 41 includes light emitting elements 41a and 41b, for example. The light emitting elements 41a and 41b may be disposed inward of the light emitting elements 21a through 21d on the upper surface 10a of the base member 10. The light emitting device 2 includes a circuit 60, including peripheral circuits of the light emitting elements 41a and 41b, in place of the circuit 50 of the light emitting device 1. In addition, the light emitting device 2 includes, as a connection terminal, a second power terminal 15c disposed on the upper surface 10a of the base member 10, in addition to the first power terminal 15a and the ground terminal 15b of the light emitting device 1. The light emitting device 2 can be used for a lighting device, such as a stop lamp and/or a tail lamp of an automobile, a motorcycle, or the like, for example.

The circuit 60 illustrated in FIG. 16 includes a drive circuit 61 and the light emitting elements 41a and 41b, in addition to the configuration of the circuit 50 illustrated in FIG. 6. The drive circuit 61 is formed of a rectifier diode 60a, and resistors 60b and 60c. The rectifier diode 60a, the resistors 60b and 60c, and the light emitting elements 41a and 41b are connected in series.

An anode of the rectifier diode 60a is connected to the second power terminal 15c. The rectifier diode 60a can protect the light emitting elements 41a and 41b from a negative polarity surge and also provide protection against a reverse connection. The resistors 60b and 60c are resistors connected between a cathode of the rectifier diode 60a and the light emitting element 41a, and adjust a current flowing through the light emitting elements 41a and 41b.

As described above, the drive circuit 61 does not include an integrated circuit or a transistor, but includes the rectifier diode 60a and the resistors 60b and 60c connected in series to the cathode of the rectifier diode 60a. The light emitting elements 41a and 41b emit light in response to the current supplied from the second power terminal 15c via the rectifier diode 60a and the resistors 60b and 60c.

The circuit 60 may include a peripheral circuit of the drive circuit 61, as necessary. In the illustrated example, the circuit 60 includes capacitors 60d and 60e and a Zener diode 60f, as the peripheral circuit of the drive circuit 61. The capacitors 60d and 60e are capacitors for noise suppression, and are connected in series between the second power terminal 15c and the ground terminal 15b. The capacitors 60d and 60e can reduce radio frequency noise from sources such as wireless communications, noise induced in cables, or the like, for example. The Zener diode 60f is connected between the second power terminal 15c and the ground terminal 15b, and protects the light emitting elements 41a and the 41b from a positive polarity surge.

In the light emitting device 2, the drive circuit 51 and the drive circuit 61 can be driven independently, and thus, the light emitting elements 21a through 21d and the light emitting elements 41a and 41b can be caused to emit light simultaneously or at different timings. The light emitting elements 21a through 21d can be used as a stop lamp of an automobile, for example, and the light emitting elements 41a and 41b can be used as a tail lamp of the automobile, for example.

In the light emitting device 2, the first interconnect 11 is disposed on the upper surface 10a of the base member 10, and the second interconnect 12 is disposed on the lower surface 10b of the base member 10, similar to the light emitting device 1. Further, the first interconnect 11 and the second interconnect 12 are connected via the conductive member 13. For example, in FIG. 13, the portion connecting the ground terminal 15b and the MOSFET 50b is a portion of the first ground interconnect 11G1, and four conductive members 13 are located at positions overlapping this portion of the first ground interconnect 11G1 in the plan view. The portion connecting the ground terminal 15b and the MOSFET 50b corresponds to a position indicated by a broken line C in the circuit diagram of FIG. 16.

As described above, in the light emitting device 2, the base member 10 is formed of a ceramic material, the first interconnect 11 is disposed on the upper surface 10a of the base member 10, and the second interconnect 12 is disposed on the lower surface 10b of the base member 10. The first interconnect 11 and the second interconnect 12 are connected via the conductive member 13. As a result, the noise resistance of the light emitting device 2 can be improved, similar to the light emitting device 1.

### <First Modification of Second Embodiment>

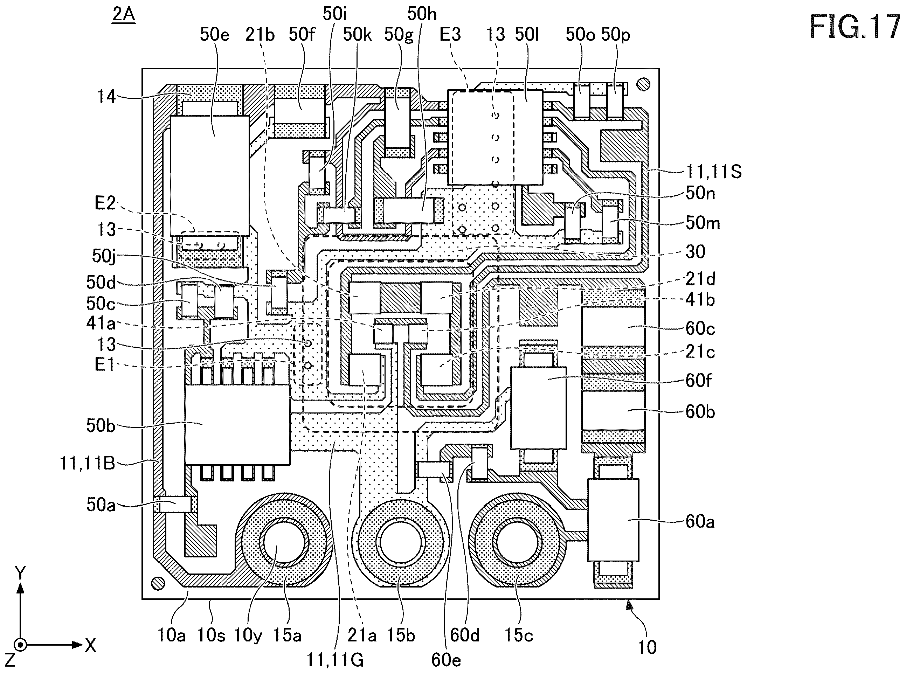

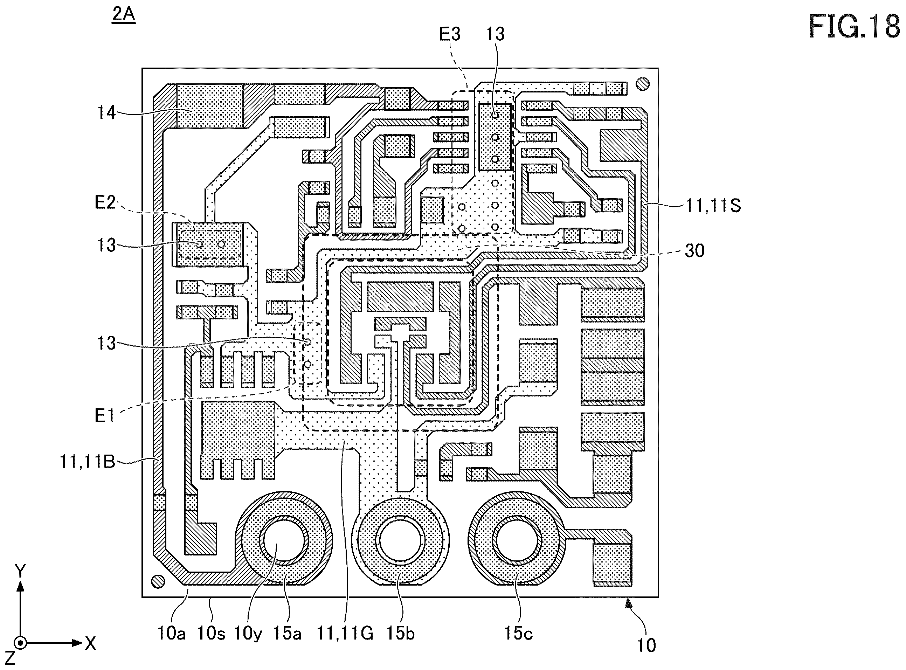

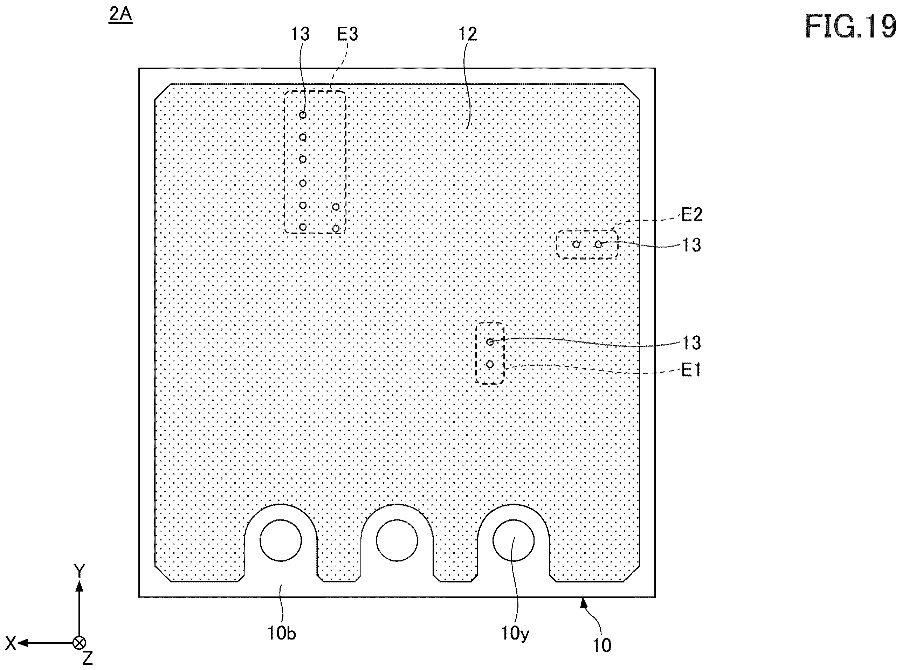

FIG. 17 and FIG. 18 are top views illustrating an example of the light emitting device according to a first modification of the second embodiment. In FIG. 17, the illustration of the light transmitting member and the frame member is omitted for the sake of convenience, and the position of the frame member is indicated by a broken line. In FIG. 18, the illustration of the light source, the frame member, and the electronic components is omitted for the sake of convenience, and the position of the frame member is indicated by a broken line. FIG. 19 is a bottom view illustrating the example of the light emitting device according to the first modification of the second embodiment.

In a light emitting device 2A illustrated in FIG. 17 through FIG. 19, the position of the conductive member 13 differs from that of the light emitting device 1 illustrated in FIG. 14. In the light emitting device 2A, the conductive members 13 are disposed in three areas E1, E2, and E3 indicated by a broken line in the circuit diagram of FIG. 16. The positions of the areas E1, E2, and E3 indicated by the broken line in the circuit diagram of FIG. 16 are included in the first ground interconnect 11G1.

Accordingly, the position of the conductive member 13 is not particularly limited, and the conductive member 13 may be disposed at any position of the base member 10. The noise resistance of the light emitting device can be improved regardless of the position of the conductive member 13 on the base member 10.

Although the preferred embodiments or the like have been described above in detail, the present invention is not limited to the embodiments or the like described above, and various modifications and substitutions can be made to the embodiments or the like described above without departing from the scope of the present invention.

According to the embodiments and modifications of the present disclosure, the noise resistance of the light emitting device can be improved.

Although the embodiments are numbered with, for example, "first," or "second," the ordinal numbers do not imply priorities of the embodiments. Many other variations and modifications will be apparent to those skilled in the art.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a illustrating of the superiority and inferiority of the invention. Although the embodiments of the present invention have been described in detail, it should be understood that the various changes, substitutions, and alterations could be made hereto without departing from the spirit and scope of the invention.

## Claims

1. A light emitting device (1, 1A-1D, 2, 2A) comprising:
a base member (10) formed of a ceramic material and defining a through hole (10x);
a first interconnect (11) disposed on an upper surface of the base member (10);
a second interconnect (12) disposed on a lower surface of the base member (10);
a conductive member (13) disposed inside the through hole (10x) and electrically connecting the first interconnect (11) and the second interconnect (12);
a light emitting element (21, 21a-21d, 41a, 41b) disposed on the first interconnect (11) and electrically connected to the first interconnect (11); and
an integrated circuit (50l) disposed on the first interconnect (11) and electrically connected to the first interconnect (11).

2. The light emitting device (1, 1A-1D, 2, 2A) as claimed in claim 1, further comprising:
a ground terminal (15b) disposed on the upper surface of the base member (10), wherein:
the first interconnect (11) comprises a ground interconnect (11G) electrically connected to the ground terminal (15b),
the ground interconnect (11G) comprises a first ground interconnect (11G1) electrically connecting the ground terminal (15b) and the integrated circuit (501), and
the conductive member (13) is located at a position overlapping the first ground interconnect (11G1) in a plan view.

3. The light emitting device (1, 1A-1D, 2, 2A) as claimed in claim 2, further comprising:
a power terminal (15a) disposed on the upper surface of the base member (10), wherein:
the first interconnect (11) comprises a power interconnect (11B) electrically connected to the power terminal (15a), and a signal interconnect (11S) electrically connected to the integrated circuit (50l), and
at least a portion of each of the ground interconnect (11G), the power interconnect (11B), and the signal interconnect (11S) overlaps the second interconnect (12) in the plan view.

4. The light emitting device (1, 1A-1D, 2, 2A) as claimed in any one of claims 1 to 3, wherein:
a plurality of electronic components (50) are disposed on the first interconnect (11), the plurality of electronic components (50) including the light emitting element (21, 21a-21d, 41a, 41b) and the integrated circuit (501), and
in a plan view, a total area of portions of the first interconnect (11) where the electronic components (50) are not disposed is larger than a total area of portions of the first interconnect (11) where the electronic components (50) are disposed.

5. The light emitting device (1, 1A-1D, 2, 2A) as claimed in claim 4, wherein the conductive member (13) is not in contact with a bonding material that bonds the electronic components (50) to the first interconnect (11).

6. The light emitting device (1, 1A-1D, 2, 2A) as claimed in any one of claims 1 to 5, wherein, in a plan view of an entirety of the base member (10), an area of a portion of the base member (10) where the first interconnect (11) and the second interconnect (12) overlap is larger than an area of a portion of the base member (10) where the first interconnect (11) and the second interconnect (12) do not overlap.

7. The light emitting device (1B-1D) as claimed in any one of claims 1 to 6, further comprising:
an insulating film (16) disposed on a lower surface of the second interconnect (12) at a position covering at least part of the lower surface of the base member (10).

8. The light emitting device (1C, 1D) as claimed in claim 7, wherein:
the lower surface of the base member (10) includes a first area (121) overlapping the light emitting element (21, 21a-21d) in a plan view and where the second interconnect (12) is not disposed, and
at least a portion of the first area (121) is exposed from the insulating film (16).

9. The light emitting device (1D) as claimed in claim 8, wherein:
the lower surface of the base member (10) includes a second area (122) overlapping the integrated circuit (501) in the plan view and where the second interconnect (12) is not disposed, and
at least a portion of the second area (122) is exposed from the insulating film (16).

10. The light emitting device (1C) as claimed in claim 8 or 9, wherein, in the plan view, the first area (121) is continuously surrounded by the second interconnect (12).

11. The light emitting device (1, 1A-1D, 2, 2A) as claimed in any one of claims 1 to 10, further comprising:
a wavelength conversion member (22) covering the light emitting element (21, 21a-21d, 41a, 41b), wherein:
the wavelength conversion member (22) comprises phosphor particles,
the light emitting element (21, 21a-21d, 41a, 41b) is configured to emit blue light, and
the wavelength conversion member (22) is configured to emit red light upon being excited by the blue light.
